# EUROPEAN PATENT APPLICATION

(11) **EP 3 702 883 A1**
(43) Date of publication of application: **02.09.2020**
(21) Application number: 20159294.6
(22) Date of filing: 25.02.2020
(51) Int. Cl.: G06F 1/18, G11B 33/12, F16F 15/04, H01R 12/00

(54) **HARD DISK FIXING STRUCTURE**

(30) Priority: 26.02.2019 JP 2019033284
(71) Applicant: KYOCERA Document Solutions Inc., Osaka-shi, Osaka 540-8585 (JP)
(72) Inventor: Wakayama, Kei, Osaka-shi, Osaka 540-8585 (JP)
(74) Representative: Müller Schupfner & Partner Patent- und Rechtsanwaltspartnerschaft mbB

(57) **Abstract**

A fixing structure includes one holding member (40) to be fixed to an electronic device (2). A hard disk (20) is fixed to the holding member (40) with a first vibration isolation member (51) interposed therebetween, and a connection conversion board (30) is fixed to the holding member (40) with a second vibration isolation member (53) interposed therebetween.

## Description

### FIELD OF INVENTION

The technology disclosed herein relates to a hard disk fixing structure.

### BACKGROUND

A fixing structure has been known that fixes mutually opposed end surfaces of a flat, rectangular hard disk to an electronic device via plate-shaped support brackets. The hard disk is fixed to each support bracket by means of an attachment screw. A rubber shock absorber (vibration isolation member) is interposed between the attachment screw and the support bracket.

A known hard disk of this type has a connector of the SATA standard. A USB-SATA conversion board is used to mount such a hard disk on an electronic device having a connector of the USB standard. The USB-SATA conversion board is configured by mounting a USB connector and a SATA connector on one board.

In the case where the USB-SATA conversion board is attached to the hard disk, the USB-SATA conversion board is typically held by the SATA connector of the hard disk in a state of floating from the electronic device without being fixed to the electronic device.

### SUMMARY

An aspect of the present disclosure provides a fixing structure for fixing a hard disk and a connection conversion board to an electronic device. The hard disk has a connector of a predetermined standard. The connection conversion board has a first connector to be connected to the connector of the hard disk, and a second connector of a different standard from the first connector.

The fixing structure includes one holding member to be fixed to the electronic device. The hard disk is fixed to the holding member with a first vibration isolation member interposed therebetween. The connection conversion board is fixed to the holding member with a second vibration isolation member interposed therebetween.

### BRIEF DESCRIPTION OF THE DRAWINGS

FIG. 1 is a perspective view of the appearance of an image forming apparatus in an embodiment that includes a fixing structure for fixing a hard disk and a connection conversion board;
FIG. 2 is a block diagram illustrating a control configuration of the image forming apparatus;
FIG. 3 is an enlarged perspective view of an image forming apparatus body, shown with an outer cover detached;
FIG. 4 is a perspective view of an HDD assembly;
FIG. 5 is a perspective view similar to FIG. 3, shown with the HDD assembly removed;
FIG. 6 is a perspective view of the HDD assembly as viewed from the hard disk side;
FIG. 7 is a perspective view of the hard disk alone;
FIG. 8 is a perspective view of the connection conversion board alone;
FIG. 9 is a perspective view of a holding member alone;
FIG. 10 is a sectional view taken along line X-X in FIG. 6;
FIG. 11 is a perspective view of the appearance of a first vibration isolation member; and
FIG. 12 is a sectional view taken along line XII-XII in FIG. 6.

### DETAILED DESCRIPTION

Hereinafter, an example embodiment of the present disclosure will be described in detail on the basis of the drawings. It should be understood that the technology disclosed herein is not limited to the embodiment described below.

### [Overall configuration]

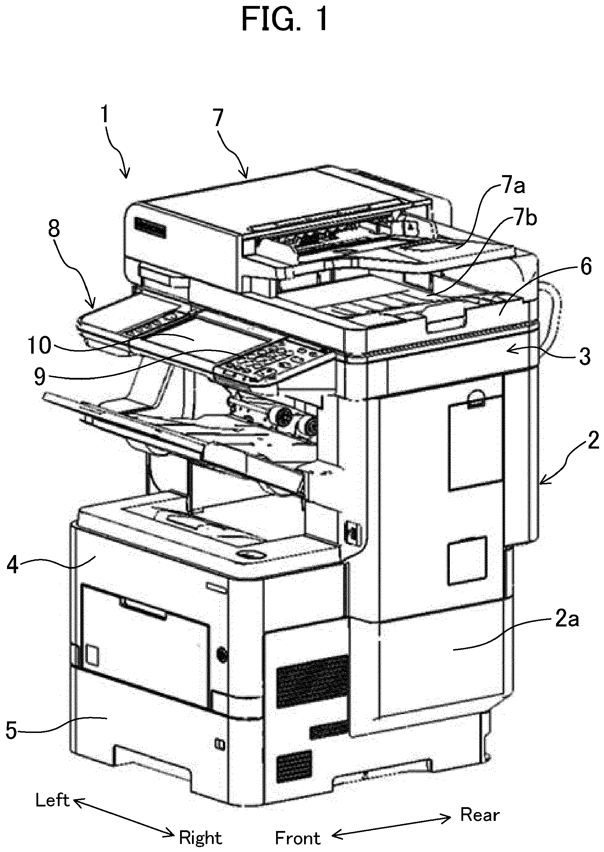

FIG. 1 shows an image forming apparatus 1 in Embodiment 1. The image forming apparatus 1 is a combined image forming apparatus (multifunction device) having a printing function and also having a scanner function, a facsimile function, and a copying function. Note that, in the description below, the terms "front-side" and "rear-side" refer to the front side and rear side of the image forming apparatus 1, respectively, and the terms "left-side" and "right-side" refer to the left side and right side of the image forming apparatus 1 as viewed from the front side thereof, respectively.

The image forming apparatus 1 includes an image forming apparatus body 2 (example of electronic device) and an image reading unit 3 arranged above the image forming apparatus body 2. The image forming apparatus body 2 has a printing unit 4 that is located intermediately in a vertical direction of the image forming apparatus 2, and a plurality of sheet feed cassettes 5 that are located under the printing unit 4. Each sheet feed cassette 5 contains sheets of a different size from the others. The printing unit 4 conducts printing on a sheet fed from any of the sheet feed cassettes 5, on the basis of given image data. The printing unit 4 employs an electrophotographic printing method. That is to say, the printing unit 4 forms an electrostatic latent image on a photosensitive drum surface by directing a laser beam corresponding to image data onto the photosensitive drum surface, and transfers the electrostatic latent image onto a sheet by developing the electrostatic latent image with a toner.

The image reading unit 3 optically reads an image of a document placed on a contact glass as a top surface of the image reading unit 3. The top surface of the image reading unit 3 is openably and closably covered with a document cover 6 for pressing a placed document. The document cover 6 is integrated with an automatic document feeder 7. The automatic document feeder 7 feeds a document set in a document feed tray 7a along a predetermined feed path to cause the document to pass through an image reading position set on the contact glass, and then discharges the document into a document exit tray 7b. The image reading unit 3 has an operation panel 8 thereon that is formed to protrude from the front face of the image reading unit 3. The operation panel 8 has provided thereon an operating unit 9 including numeric keys and a start key, and a displaying unit 10 composed of a liquid crystal display.

### [Configuration of control system]

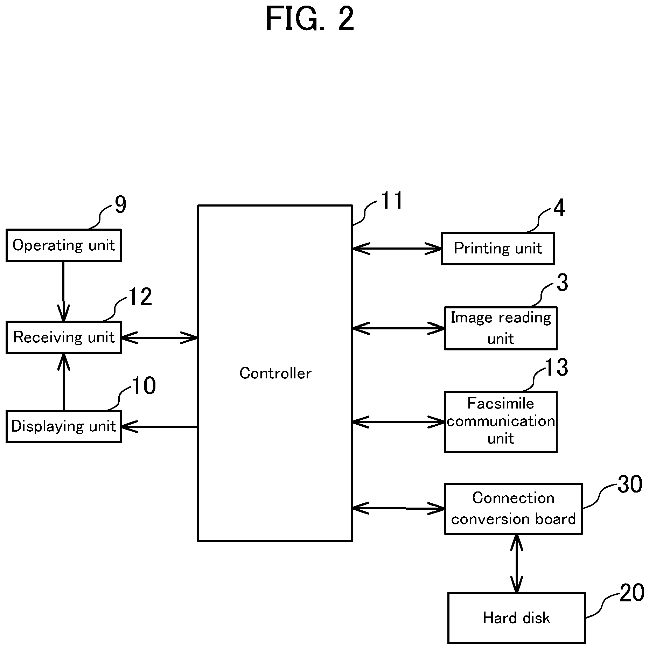

Next, the configuration of a control system of the image forming apparatus 1 is described with reference to FIG. 2. The image forming apparatus 1 includes a controller 11 for controlling the operation of the whole image forming apparatus 1. The controller 11 is composed of a microcomputer including a CPU, a RAM, and a ROM. The controller 11 is connected to a receiving unit 12, the image reading unit 3, the printing unit 4, the displaying unit 10, and a facsimile communication unit 13. Further, the controller 11 is connected to an HDD (hard disk drive, hereinafter simply referred to as "hard disk") 20 via a connection conversion board 30.

The controller 11 controls the operations of the image reading unit 3, printing unit 4, displaying unit 10, and facsimile communication unit 13 in accordance with signals input from the receiving unit 12.

The receiving unit 12 is connected to the operating unit 9 via a signal line. The receiving unit 12 receives operation signals from the operating unit 9 and outputs them to the controller 11. The operation signals include a signal indicative of which one of the printing function, scanner function, copying function, and facsimile function is selected by the user, and a signal indicative of the number of sheets to be subjected to printing input by the user using the numeric keys.

In accordance with signals input from the receiving unit 12, the controller 11 operates as follows: when determining that the printing function is set, the controller 11 controls the printing unit 4 to execute a predetermined printing process; when determining that the scanner function is set, the controller 11 controls the image reading unit 3 to execute a predetermined image reading process; when determining that the copying function is set, the controller 11 controls the image reading unit 3 and the printing unit 4 to execute a predetermined copying process; and when determining that the facsimile function is set, the controller 11 controls the facsimile communication unit 13 to execute a predetermined facsimile communication process.

The hard disk 20 stores data such as image data read by the image reading unit 3 and printing data transmitted to the image forming apparatus 1 from an external terminal, e.g., a computer.

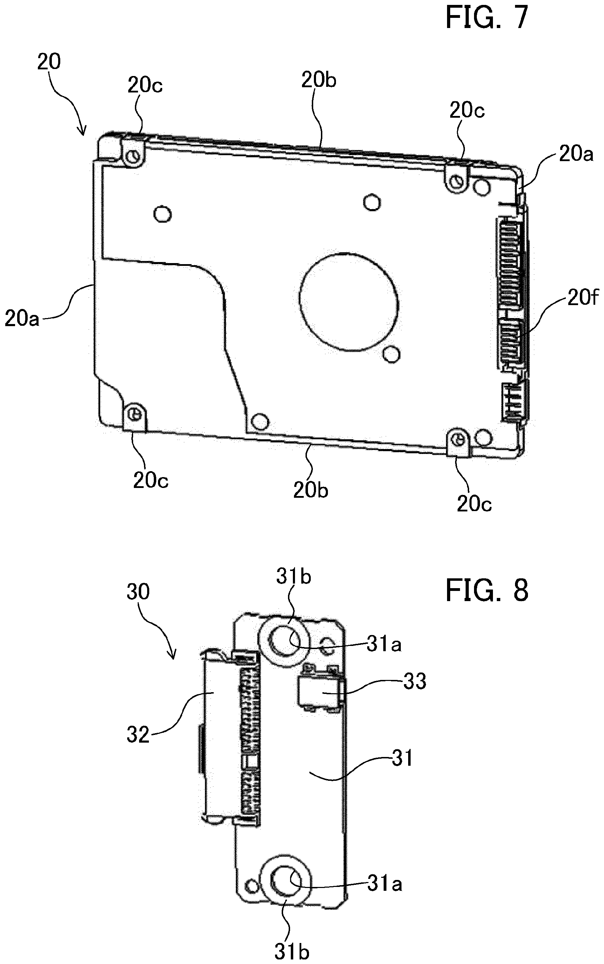

The connection conversion board 30 is interposed between two connectors of different standards from each other to connect them so that they can mutually transmit and receive signals. The connection conversion board 30 in this embodiment is composed of, for example, a SATA-USB conversion board. As described later, the SATA-USB conversion board is interposed between a connector of the SATA standard (hereinafter referred to as "SATA connector") 20f, which is provided on the hard disk 20 (see FIG. 7), and a USB connector 14, which is provided in the image forming apparatus body 2, to connect them so that they can mutually transmit and receive signals.

### [Structure for mounting hard disk 20]

The hard disk 20 is housed in a space inside an outer cover 2a of the image forming apparatus body 2 (see FIG. 1). The outer cover 2a is detachably attached to a lower end portion of a right-side surface of the image forming apparatus body 2.

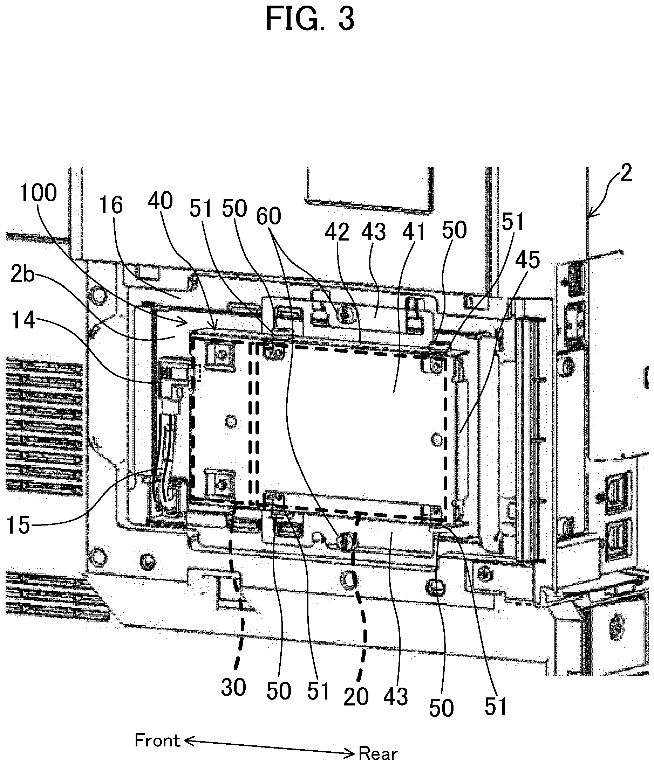

FIG. 3 is a side perspective view with the outer cover 2a detached. The hard disk 20 and the connection conversion board 30 are held by a holding member 40, thereby constituting an HDD assembly 100. The HDD assembly 100 is fixed to a rectangular frame member 16 by screws 60. The frame member 16 constitutes a part of a shield box housing a controller board (not illustrated).

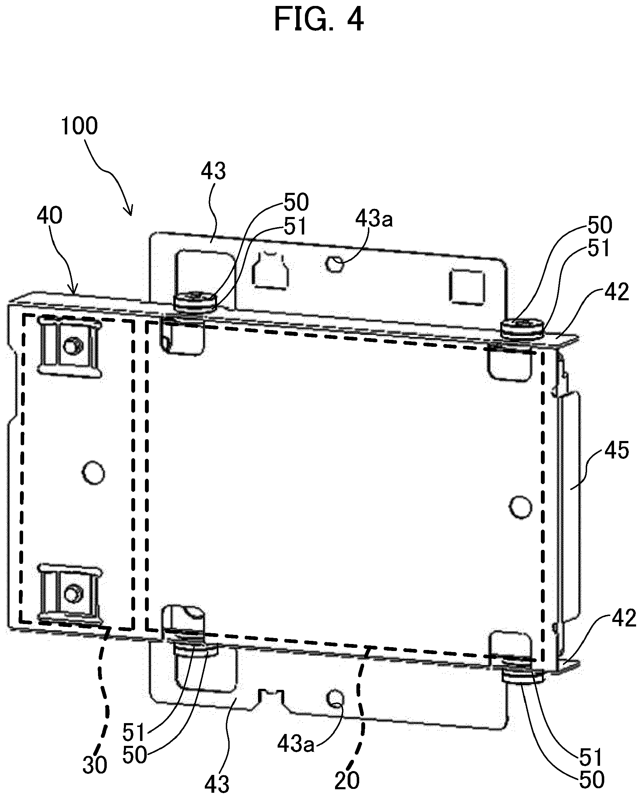

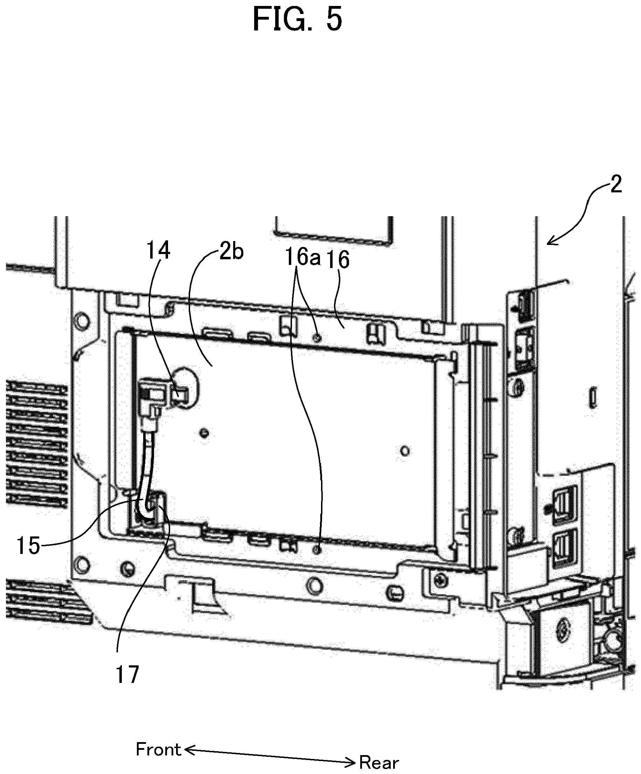

FIG. 4 is a perspective view of the HDD assembly 100. FIG. 5 is a perspective view similar to FIG. 3, shown with the HDD assembly 100 removed.

As shown in FIG. 5, the frame member 16 has formed therein two screw holes 16a for fixing the HDD assembly 100. A central opening of the frame member 16 is closed by an inner cover 2b. The controller board (not illustrated) that has the controller 11 mounted thereon is housed in a space inside the inner cover 2b. A USB connector 14 is mounted on a front-side end portion of a surface of the inner cover 2b. The USB connector 14 is connected to the controller board via a harness 15. The inner cover 2b has a cutout formed at a front-side lower corner thereof, in which cutout an insertion pipe 17 for inserting the harness 15 therethrough is arranged.

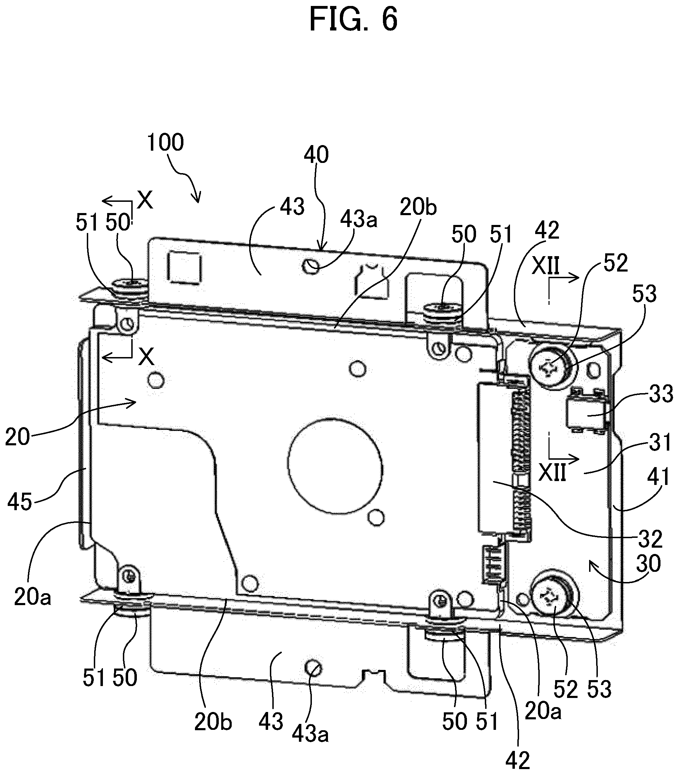

FIG. 6 is a perspective view of the HDD assembly 100 illustrated in FIG. 4 as viewed from the hard disk 20 side. As shown in FIG. 6, the holding member 40 is formed by bending a metal plate into a square U-shape. The hard disk 20 and the connection conversion board 30 are arranged adjacently to each other in a front-rear direction thereof (lateral direction in FIG. 6) and disposed inside the square U-shape of the holding member 40. The hard disk 20 is fixed to the holding member 40 by four first headed pins 50. A first vibration isolation member 51 is interposed between each first headed pin 50 and the holding member 40. The connection conversion board 30 is fixed to the holding member 40 by two second headed pins 52. A second vibration isolation member 53 is interposed between each second headed pin 52 and the holding member 40.

Here, prior to detailed description of the structure for fixing the hard disk 20 and the connection conversion board 30 to the holding member 40, each of the configurations of the hard disk 20, connection conversion board 30, and holding member 40 is described on the basis of the figure in which it is illustrated alone.

### [Configuration of hard disk 20]

FIG. 7 is a perspective view of the hard disk 20 alone. The hard disk 20 is formed in a flat, rectangular shape. The hard disk 20 has a pair of first end surfaces 20a opposed to each other in a longitudinal direction of the hard disk 20, and a pair of second end surfaces 20b opposed to each other in a lateral direction (direction perpendicular to the longitudinal direction) of the hard disk 20. A connector of the SATA standard (hereinafter referred to as "SATA connector") 20f is provided on one of the pair of first end surfaces 20a of the hard disk 20. The SATA connector 20f in this example is a male connector with multiple pins. A direction of fitting of the SATA connector 20f is coincident with the longitudinal direction of the hard disk 20.

Each second end surface 20b of the hard disk 20 has two screw holes 20c formed therein that are spaced from each other in the longitudinal direction of the hard disk 20. The screw holes 20c are used for fixing the hard disk 20 to the holding member 40.

### [Configuration of connection conversion board 30]

FIG. 8 is a perspective view of the connection conversion board 30 alone. The connection conversion board 30 has a rectangular plate-shaped board body 31. The board body 31 has a longitudinal dimension (dimension in the vertical direction in FIG. 8) substantially equal to a lateral dimension of the hard disk 20.

The board body 31 has a SATA connector 32 (first connector) mounted thereon at one of two longitudinal edges thereof, and has a USB connector 33 (second connector) mounted thereon at the other of the two longitudinal edges thereof. The SATA connector 32 and the USB connector 33 are positioned to be shifted to one side in the longitudinal direction of the board body 31. The SATA connector 32 and the USB connector 33 are mounted on the board body 31 and connected to each other so that they can mutually transmit and receive signals.

The SATA connector 32 is fitted with the SATA connector 20f of the hard disk 20. The SATA connector 32 is a female connector with multiple pin holes. Note that the male-female relation of the SATA connector 20f of the hard disk 20 and the SATA connector 32 of the connection conversion board 30 may be reversed.

The board body 31 has attachment holes 31a (second attachment hole) respectively formed therein at both ends in the longitudinal direction thereof. At a peripheral edge of each attachment hole 31a, an annular protruding seat portion 31b is formed with a very small difference in level.

### [Configuration of holding member 40]

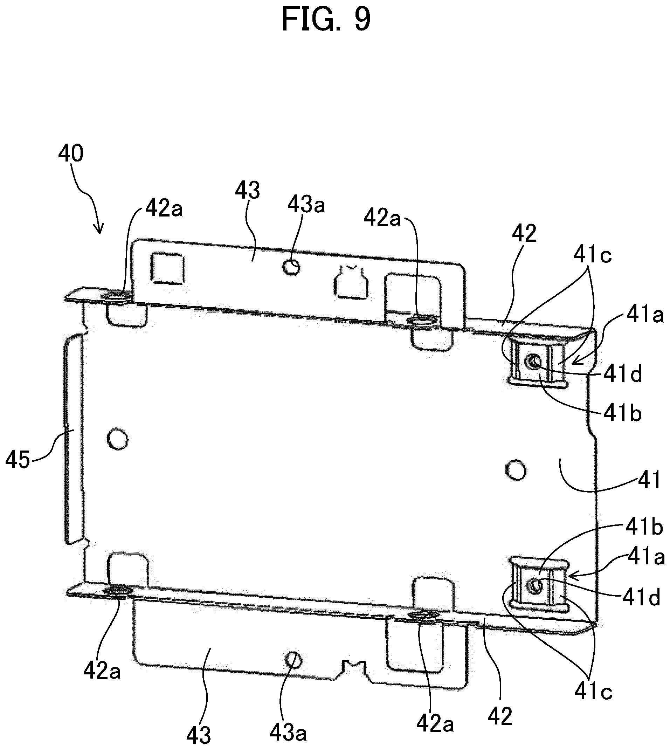

FIG. 9 is a perspective view pf the holding member 40 alone. The holding member 40 is formed by bending a metal plate. Specifically, the holding member 40 has a rectangular base-plate part 41 and a pair of upright plates 42 respectively standing from two longitudinal edges of the base-plate part 41. The pair of upright plates 42 are opposed to each other in a lateral direction of the base-plate part 41.

Each upright plate 42 has a pair of attachment holes 42 (first attachment hole) formed therein that penetrate in a thickness direction of the upright plate 42 and are spaced from each other in a base-plate longitudinal direction.

Further, a fixation plate 43 is connected to a distal edge of each upright plate 42 such that it protrudes outward in the base-plate lateral direction. Each fixation plate 43 has an attachment hole 43a formed therein for fixing the holding member 40 to the frame member 16. The fixation plates 43 are fixed to the frame member 16 by the screws 60 inserted through the attachment holes 43a (see FIG. 3).

A regulation plate 45 is connected to one side edge in the longitudinal direction of the base-plate part 41 such that it is vertical to the base-plate part 41. The regulation plate 45 facilitates positioning of the hard disk 20 in the assembling process. From the perspective of inhibiting transmission of vibration, the regulation plate 45 is formed such that it does not contact the hard disk 20 when it has been assembled.

On an end portion of the base-plate part 41 located on the side opposite to the regulation plate 45, a pair of protruding seat portions 41a are formed by pressing. The pair of protruding seat portions 41a are spaced from each other in the base-plate lateral direction. The protruding seat portions 41a are respectively located near inner surfaces of the upright plates 42. Each protruding seat portion 41a is formed to have a trapezoidal shape as viewed in the base-plate lateral direction. Specifically, each protruding seat portion 41a has a flat part 41b and inclined parts 41c respectively connected to both edges of the flat part 41b. The flat part 41b has a screw hole 41d formed therein that penetrates in a thickness direction of the flat part 41b.

### [Structure for fixing hard disk 20 to holding member 40]

Next, the structure for fixing the hard disk 20 to the holding member 40 is described with reference to FIGS. 6, 10, and 11.

As shown in FIG. 6, the hard disk 20 is fixed to the holding member 40 by four first headed pins 50. In the state where the hard disk 20 is fixed to the holding member 40, a clearance is present between a back surface of the hard disk 20 and the base-plate part 41 of the holding member 40, and a very small clearance is present between each second end surface 20b of the hard disk 20 and each upright plate 42 of the holding member 40.

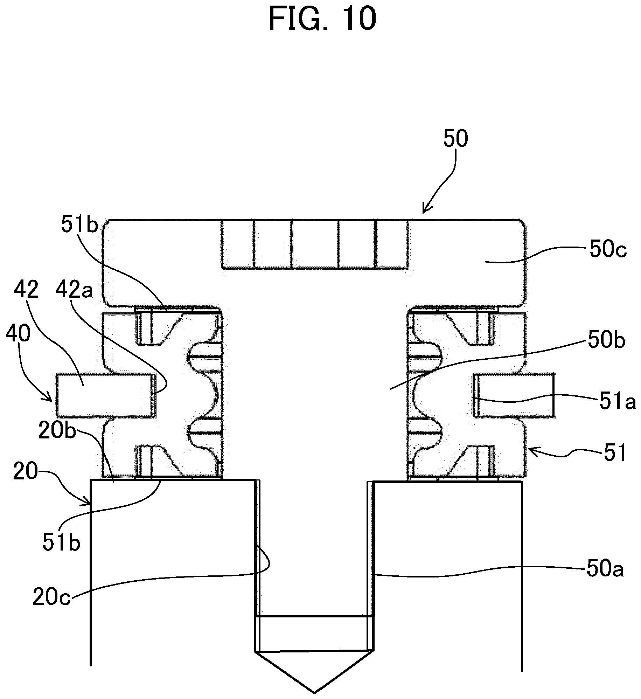

FIG. 10 is a vertical sectional view of the first headed pin 50 taken along the axis thereof (sectional view taken along line X-X in FIG. 6). The first headed pins 50 are respectively screwed in the screw holes 20c formed in the second end surfaces 20b of the hard disk 20 through the attachment holes 42a formed in the upright plates 42 of the holding member 40.

Each first headed pin 50 has a threaded shank 50a, a pin part 50b formed on a base end of the threaded shank 50a, and a head 50 connected to a base end of the pin part 50b. The pin part 50b has a greater diameter than the threaded shank 50a, and the head 50c has a greater diameter than the pin part 50b.

Between the pin part 50b of each first headed pin 50 and an inner peripheral surface of each attachment hole 42a of the upright plates 42, a first vibration isolation member 51 is provided.

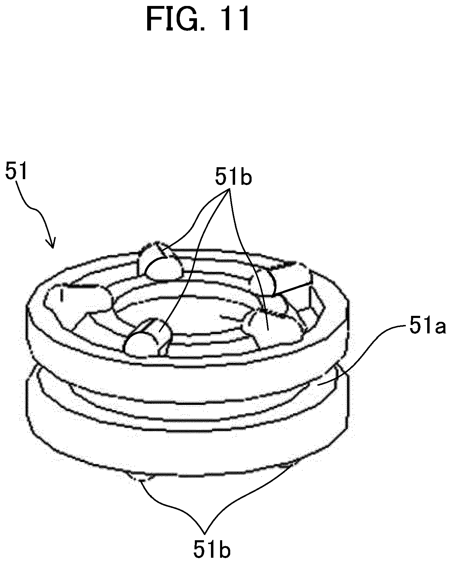

As shown in FIG. 11, the first vibration isolation member 51 is formed by forming a groove 51a in a peripheral surface of a ring-shaped elastic member. The first vibration isolation member 51 has a plurality of semi-circular cylindrical contact protrusions 51b radially formed on both surfaces in an axial direction thereof. The groove 51a of the first vibration isolation member 51 is engaged with a peripheral edge of the attachment hole 42a formed in the upright plate 42.

As shown in FIG. 10, the part of the first vibration isolation member 51 located on one side (lower side in FIG. 10) of the groove 51a in the axial direction of the first vibration isolation member 51 is interposed between the upright plate 42 and the second end surface 20b of the hard disk 20. Further, the part of the first vibration isolation member 51 located on the other side (upper side in FIG. 10) of the groove 51a in the axial direction of the first vibration isolation member 51 is interposed between the head 50c of the first headed pin 50 and the upright plate 42.

Thus, the first vibration isolation member 51 functions to prevent vibration generated in the image forming apparatus body 2 from being transmitted to the hard disk 20 through the holding member 40 and the first headed pin 50.

### [Structure for fixing connection conversion board 30 to holding member 40]

With reference to FIG. 6, the connection conversion board 30 is fixed to the holding member 40 by two second headed pins 52.

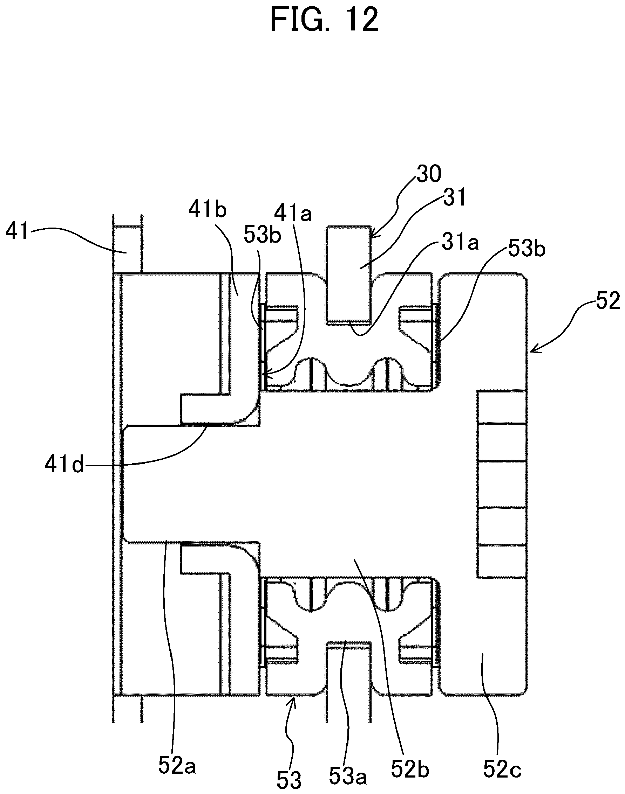

FIG. 12 is a vertical sectional view of the second headed pin 52 taken along the axis thereof (sectional view taken along line XII-XII in FIG. 6). Similarly to the first headed pins 50 described above, each second headed pin 52 has a threaded shank 52a, a pin part 52b, and a head 52c. The second headed pins 52 are respectively screwed in the screw holes 41d formed in the protruding seat portions 41a of the holding member 40 through the attachment holes 31a formed in the connection conversion board 30 (board body 31). Between the pin part 52b of each second headed pin 52 and each attachment hole 31a of the connection conversion board 30, a second vibration isolation member 53 is provided.

Similarly to the first vibration isolation members 51 described above, each second vibration isolation member 53 is composed of a ring-shaped elastic member and has a ring groove 53a and a plurality of contact protrusions 53b.

The ring groove 53a of the second vibration isolation member 53 is engaged with a peripheral edge of the attachment hole 31a formed in the connection conversion board 30 (board body 31). The part of the second vibration isolation member 53 located on one side (left side in FIG. 12) of the ring groove 53a in the axial direction of the second vibration isolation member 53 is interposed between the connection conversion board 30 and the protruding seat portion 41a of the base-plate part 41. The part of the second vibration isolation member 53 located on the other side (right side in FIG. 12) of the ring groove 53a in the axial direction of the second vibration isolation member 53 is interposed between the head 52c of the second headed pin 52 and the connection conversion board 30.

Thus, the second vibration isolation member 53 functions to prevent vibration generated in the image forming apparatus body 2 from being transmitted to the hard disk 20 through the holding member 40 and the connection conversion board 30.

### [Operational effects]

In this embodiment, as having been described above, the hard disk 20 is fixed to the holding member 40 with the first vibration isolation members 51 interposed therebetween, and the connection conversion board 30 is fixed to the holding member 40 with the second vibration isolation members 53 interposed therebetween.

Since this configuration has the connection conversion board 30 fixed to the holding member 40 with the second vibration isolation members 53 interposed therebetween, unlike the conventional fixing structure, the connection conversion board 30 is prevented from floating from the base-plate part 41 due to it being supported only by the SATA connector 20f of the hard disk 20. Consequently, the connection between the SATA connector 20f of the hard disk 20 and the SATA connector 32 of the connection conversion board 30 is not easily released. Further, because of the provision of the second vibration isolation members 53, vibration is less likely to be transmitted to the connection conversion board 30 from the holding member 40. Consequently, vibration generated in the image forming apparatus body 2 is prevented from being transmitted to the hard disk 20 through the connection conversion board 30. Furthermore, because of the provision of the first vibration isolation members 51, transmission of vibration to the hard disk 20 from the holding member 40 is also inhibited.

In this embodiment, the holding member 40 has the base-plate part 41 that faces the back surface (one side surface in the thickness direction) of the hard disk 20, and the pair of upright plates 42 that stand from the base-plate part 41 and respectively face the mutually opposed second end surfaces 20b of the hard disk 20. Each upright plate 42 has the attachment holes 42a formed therein that penetrate in the thickness direction of the upright plate 42, and the connection conversion board 30 has the attachment holes 31a formed therein that penetrate in the thickness direction of the connection conversion board 30. The first headed pins 50 are respectively coupled to the hard disk 20 through the attachment holes 42a of the upright plates 42, and the second headed pins 52 are respectively coupled to the base-plate part 41 of the holding member 40 through the attachment holes 31a of the connection conversion board 30.

The first vibration isolation members 51 are formed so as to be interposed between the upright plates 42 and the second end surfaces 20b of the hard disk 20 in a state of being respectively attached between the first headed pins 50 and the inner peripheral surfaces of the attachment holes 42a of the upright plates 42. The second vibration isolation members 53 are formed so as to be interposed between the connection conversion board 30 and the base-plate part 41 of the holding member 40 in a state of being respectively attached between the second headed pins 52 and the inner peripheral surfaces of the attachment holes 31a of the connection conversion board 30.

With this configuration, transmission of vibration to the hard disk 20 from the holding member 40 as well as transmission of vibration to the hard disk 20 through the connection conversion board 30 from the holding member 40 are reliably inhibited with a simple structure.

Further, the base-plate part 41 of the holding member 40 in this embodiment has the protruding seat portions 41a that protrude to the connection conversion board 30 side, and the second header pins 52 are respectively coupled to the screw holes 41d formed in the protruding seat portions 41a through the attachment holes 31a of the connection conversion board 30. Additionally, the second vibration isolation members 53 are formed so as to be respectively interposed between the connection conversion board 30 and the protruding seat portions 41a (portions of the base-plate parts 41).

Turning now to the conventional holding member that does not have such protruding seat portions, the conventional holding member has a large space between the base-plate part thereof and the connection conversion board, i.e., the connection conversion board floats from the base-plate part. This causes the problem that the connection between the SATA connector of the hard disk and the SATA connector of the connection conversion board is easily released.

To solve this problem, the base-plate part 41 in this embodiment is formed to have the protruding seat portions 41a thereon so that it is easy to have the connection conversion board 30 supported by the protruding seat portions 41a with the second vibration isolation members 53 interposed therebetween. Consequently, the posture of the connection conversion board 30 is stabilized and the connection between the SATA connectors 20f and 32 is therefore less likely to be released than that in the conventional fixing structure. Further, the connection conversion board 30 is coupled to the base-plate part 41 only at a small area corresponding to the protruding seat portions 41a; therefore, transmission of vibration is more suppressed than in the case where the connection conversion board 30 is entirely placed on the base-plate part 41.

Moreover, since the second vibration isolation members 53 are formed so as to be respectively interposed between the connection conversion board 30 and the protruding seat portions 41a (portions of the base-plate part 41), the difference in height between the SATA connector 20f of the hard disk 20 and the SATA connector 32 of the connection conversion board 30 can be absorbed by the second vibration isolation members 53, which does not need the height positions of seat surfaces of the protruding seat portions 41a to be managed with high accuracy. Therefore, machining accuracy requirements for the protruding seat portions 41a may be lowered so that product costs can be reduced correspondingly.

### <<Other embodiments>>

The above embodiment has been described with respect to the image forming apparatus body 2 as an example of the electronic device to which the fixing structure of the present disclosure is applicable; however, the present disclosure is not limited to the above embodiment. Examples of the electronic device include a computer, a video recorder, etc. Further, needless to say, in the case where the fixing structure of the present disclosure is applied to an image forming apparatus, the image forming apparatus is not limited to an electrophotographic type and may be an ink-jet type.

In the above embodiment, a screw engagement is employed for coupling between the first headed pins 50 and the hard disk 20. However, the present disclosure is not limited thereto, and a claw-engaged fixation, a press-fitted fixation, or any other suitable type of fixation may be employed instead.

## Claims

1. A fixing structure for fixing a hard disk (20) and a connection conversion board (30) to an electronic device (2), the hard disk (20) having a connector (20f) of a predetermined standard, the connection conversion board (30) having a first connector (32) to be connected to the connector (20f) of the hard disk (20), and a second connector (33) of a different standard from the first connector (32),
the fixing structure comprising:
one holding member (40) to be fixed to the electronic device (2),
wherein:
the hard disk (20) is fixed to the holding member (40) with a first vibration isolation member (51) interposed therebetween; and
the connection conversion board (30) is fixed to the holding member (40) with a second vibration isolation member (53) interposed therebetween.

2. The fixing structure of claim 1, wherein:
the hard disk (20) has a pair of first end surfaces (20a) opposed to each other, and a pair of second end surfaces (20b) opposed to each other;
the connector (20f) of the predetermined standard is arranged on one of the pair of first end surfaces (20a) of the hard disk (20);
the connection conversion board (30) is arranged adjacently to the one of the pair of first end surfaces (20a) of the hard disk (20);
the holding member (40) has a base-plate part (41) facing one side surface in a thickness direction of the hard disk (20), and a pair of upright plates (42) standing from the base-plate part (41) and respectively facing the pair of second end surfaces (20b) of the hard disk (20) opposed to each other;
each of the pair of upright plates (42) has formed therein a first attachment hole (42a) penetrating in a thickness direction of the upright plate (42);
the connection conversion board (30) has formed therein a second attachment hole (31a) penetrating in a thickness direction of the connection conversion board (30);
the fixing structure comprises first headed pins (50) respectively coupled to the hard disk (20) through the first attachment holes (42a) of the pair of upright plates (42), and a second headed pin (52) coupled to the base-plate part (41) through the second attachment hole (31a) of the connection conversion board (30);
the first vibration isolation member (51) is formed so as to be interposed between each of the pair of upright plates (42) and each of the pair of second end surfaces (20b) of the hard disk (20) in a state of being attached between the first headed pin (50) and an inner peripheral surface of the first attachment hole (42a); and
the second vibration isolation member (53) is formed so as to be interposed between the connection conversion board (30) and the base-plate part (41) in a state of being attached between the second headed pin (52) and an inner peripheral surface of the second attachment hole (31a).

3. The fixing structure of claim 2, wherein:
the base-plate part (41) of the holding member (40) has a protruding seat portion (41a) protruding to the connection conversion board (30) side;
the second headed pin (52) is coupled to the protruding seat portion (41a) through the second attachment hole (31a) of the connection conversion board (30); and
the second vibration isolation member (53) is formed so as to be interposed between the connection conversion board (30) and the protruding seat portion (41a).

4. The fixing structure of claim 1, wherein the first connector (32) of the connection conversion board (30) is a USB connector and the second connector (33) of the connection conversion board (30) is a SATA connector.
